# EUROPÄISCHE PATENTANMELDUNG

(11) **EP 0 696 095 A1**
(43) Veröffentlichungstag der Anmeldung: **07.02.1996**
(21) Anmeldenummer: 94112325.9
(22) Anmeldetag: 06.08.1994
(51) Int. Cl.: H01S 3/19, H01S 3/025, H04B 10/24, G02B 6/42

(54) **Struktur, Verwendung und Anordnung eines Halbleiterlasers**

(71) Anmelder: ANT Nachrichtentechnik GmbH, D-71522 Backnang (DE)
(72) Erfinder: Schwaderer, Bernhard, Dr., D-71554 Weissach im Tal (DE); Hauer, Heiner, D-70743 Fellbach (DE); Möss, Eberhard, D-71540 Murrhardt (DE); Kuke, Albrecht, Dr., D-71549 Auenwald (DE)

(57) **Zusammenfassung**

Um einen besseren Lichtdurchgang durch einen Laser im Empfangsfall bei Halbduplexbetrieb zu ermöglichen, weist die angegebene Halbleiterlaserstruktur oberhalb und eventuell auch unterhalb der aktiven Laserschicht (2) Lichtführungsschichten (7,7') mit einem Brechungsindex n₇ auf. Zur Führung des Lichtes in den Schichten dienen Mantelschichten (9) und seitliche Streifen (8,8'), die die Lichtführungsschichten (7,7') seitlich begrenzen und Brechungsindizes n₈, n₉ kleiner dem Brechungsindex der Lichtführungsschichten (7,7') n₇ aufweisen (n₈ < n₇, n₉ < n₇).

## Beschreibung

Die Erfindung betrifft eine Halbleiterlaserstruktur nach dem Oberbegriff des Patentanspruches 1, eine Verwendung der Halbleiterlaserstruktur und eine Anordnung mit einer solchen Halbleiterlaserstruktur.
Eine verbreitete Betriebsweise zur Übertragung von optischen Signalen ist der Halbduplexbetrieb. Beim Halbduplexbetrieb werden die optischen Signale für die Hin- und Rückrichtung über die selbe Faser aber nicht gleichzeitig übertragen. Während der Sendephase einer Sende-Empfangs-Anordnung wird der Empfangszweig abgeschaltet und umgekehrt. Durch diese Betriebsweise werden die Sende-Empfangsanordnungen unempfindlich gegen das nahe Übersprechen. Eine entsprechende Anordnung ist der DE 38 25 126 A1 zu entnehmen.

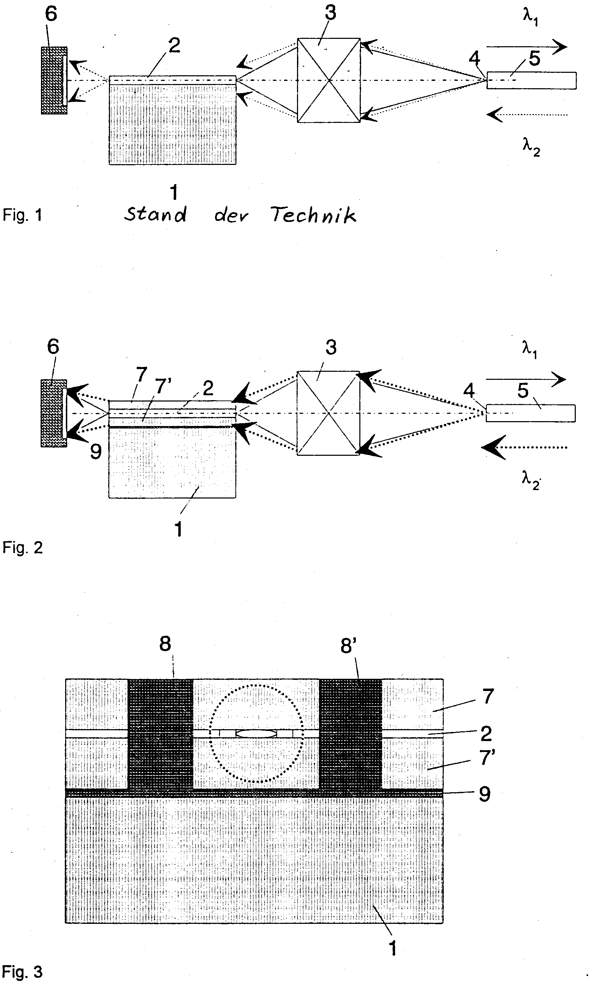

Nach dem Stand der Technik ist die in Figur 1 skizzierte Lösung vorbekannt. Ein Halbleiterlaser 1 besitzt eine optisch aktive Laserschicht 2. Das daraus aus dem vorderen Fenster austretende Licht wird über eine Abbildungsoptik 3 auf die Lichteintrittsfläche 4 einer Lichtleitfaser 5 fokussiert. Die Begrenzung des Sendestrahlenganges ist mit durchgezogenen Linien angedeutet. Das aus dem rückwärtigen Fenster austretende Laserlicht fällt auf eine Photodiode 6, die während der Sendephasen zur Regelung der Laserleistung als Monitordiode dient. Die Abbildungsoptik 3 ist erforderlich, da die Strahlcharakteristik des Halbleiterlasers sich stark von der Strahlcharakteristik einer Lichtleitfaser unterscheidet. Beim Halbleiterlaser ist z.B. die Strahltaille elliptisch mit Halbachsen zwischen ca. 0,3 µm und 1,5 µm, während z.B. bei der Einmodenfaser die Strahltaille zirkular mit einem Radius von ca. 5 µm ist.

Der Empfangszweig nach dem Stand der Technik ist mit punktierten Linien, die mit Richtungspfeilen nach hinten versehen sind, angedeutet. Das aus der Faser austretende Licht des Empfangssignals wird über die gleiche Abbildungsoptik auf die aktive Laserschicht 2 fokussiert, läuft durch die Laserschicht hindurch und trifft nach Verlassen der Schicht durch das rückwärtige Laserfenster auf die Photodiode 6, die während der Empfangsphase als Empfangsdiode dient.

Nachteilig an der Lösung nach dem Stand der Technik ist, daß der Koppelwirkungsgrad im Empfangszweig wesentlich schlechter ist, als bei der Ankopplung einer Photodiode an eine separate Empfangsfaser, bei welcher ein Koppelwirkungsgrad von fast 100 % erreicht wird. Der Grund hierfür liegt darin, daß auch sendeseitig nach dem Stand der Technik bei der Laser-Faser-Kopplung am Beispiel einer Einmodenfaser nur ein Koppelwirkungsgrad von > 20 % mit einfachen Mitteln und von > 50 % mit erheblichem Aufwand erreicht werden kann. Da in der vorgenannten Lösung für den Halbduplexbetrieb das Licht des Empfangsslgnals die gleiche Optik durchlaufen muß wie das Licht des Sendesignals, so ist hier mit etwa dem gleichen geringen Koppelwirkungsgrad zu rechnen. Der geringe Koppelwirkungsgrad hat mehrere Ursachen. Die Abbildungsoptik 3 ist im allgemeinen nicht ideal, sondern besitzt optische Abbildungsfehler, die zu einer Aufweitung des Strahls über die beugungsbegrenzte Fleckausdehnung hinausführen. Eine zirkularsymmetrische Strahltaille läßt sich über eine zirkularsymmetrische Abbildungsoptik nicht vollständig in eine elliptische Strahltaille umwandeln. Hierzu wäre eine Abbildungsoptik mit einer zylindrischen Komponente erforderlich, die aber aus Kostengründen bisher nicht eingesetzt wird. Hinzu kommen noch unvermeidliche Dejustierungen, die besonders in lateraler Richtung kritisch sind. Alle diese Gründen führen dazu, daß der Empfangsstrahl nicht auf das aktive Fenster der Laserdiode mit einer Ausdehnung von ca. 0,3 µm · 1,5 µm fokussiert wird, sondern einen größeren Bereich um das aktive Laserfenster herum mit einer Größe von vielleicht 5 µm · 5 µm trifft. Der größte Anteil des Lichtes wird daher entweder am Laserchip vorbei oder auf das Substrat des Laserchips treffen. Das dorthin gelangende Licht wird nicht geführt und erreicht daher zum größten Teil die Empfangsdiode nicht. Ein weiterer Nachteil der vorbekannten Lösung ist, daß die aktive Zone des Lasers bei Nichtbetrieb des Lasers für das Licht mit der Wellenlänge des Lasers absorbierend ist. Aus diesem Grund muß bei der vorbekannten Lösung die Empfangswellenlänge größer sein als die Sendewellenlänge, damit das Empfangslicht nicht im Laser absorbiert wird. Da in Nachrichtenübertragungssystemen aber Duplexer bzw. Halbduplexer paarweise eingesetzt werden, bei denen die Sende- und Empfangswellenlängen komplementär sind, kann die vorgenannte Lösung nur jeweils an einer Seite einer Übertragungsstrecke verwendet werden.

Es ist Aufgabe der Erfindung eine Halbleiterlaserstruktur anzugeben, mit der die genannten Nachteile beim Halbduplexbetrieb vermieden werden. Weiter ist es Aufgabe der Erfindung eine Verwendung einer solchen Halbleiterlaserstruktur und eine Anordnung mit einer solchen Halbleiterlaserstruktur anzugeben.

Die Aufgabe wird bezüglich der Halbleiterlaserstruktur durch eine Halbleiterlaserstruktur mit den Merkmalen des Patentanspruches 1, bezüglich der Verwendung durch eine Verwendung mit den Merkmalen des Patentanspruches 6 und bezüglich der Anordnung durch eine Anordnung mit den Merkmalen des Patentanspruches 7 gelöst.

Vorteilhafte Weiterbildungen der Halbleiterlaserstruktur sind in den Unteransprüchen 2 bis 5 angegeben.

Um einen besseren Lichtdurchgang beim Halbduplexbetrieb durch den Laser zu ermöglichen, weist die erfindungsgemäße Halbleiterlaserstruktur oberhalb und eventuell auch unterhalb der aktiven Zone eine Lichtführungsschicht auf. Die Dicke dieser Schichten wird so gewählt, daß ein auftreffendes Strahlbündel den Laser mit einem höheren Koppelwirkungsgrad passiert. Zur Bündelung des in den Schichten geführten Lichtes dienen in vorteilhafter Weise Mantelschichten und seitliche Streifen geringeren Brechungsindexes.

Ein Ausführungsbeispiel der Erfindung wird anhand der Zeichnungen beschrieben.

Eine Seitenansicht ist in Figur 2 dargestellt. Figur 3 zeigt die Stirnfläche einer erfindungsgemäßen Halbleiterlaserstruktur, wobei der punktierte große Kreis die Auftreffzone des Empfangslichtes und die kleine durchgezogene Ellipse die Strahltaille des Sendelichtes darstellen.

Gegenüber der vorbekannten Lösung ist bei der erfindungsgemäßen Lösung oberhalb und eventuell auch unterhalb der dünnen aktiven Zone 2 je eine Lichtführungsschicht 7 bzw. 7' aufgebracht. Diese Lichtführungsschichten haben eine Dicke von jeweils mindestens ca. 5 µm. Da sie anders als die aktive Laserschicht 2 nicht zur Lichterzeugung dienen, können sie auch für Licht der Wellenlänge des Laserlichtes transparent sein. Die Dicken d und d' der Schichten 7 und 7' werden so groß gewählt, daß das durch die nicht ideale Optik 3 aufgeweitete Strahlbündel ganz in diese Führungsschichten hineinpaßt. Der Brechungsindex n₇ der Führungsschichten 7, 7' kann dabei vom Brechungsindex n₂ der laseraktiven Schicht 2 abweichen, insbesondere kann er auch kleiner sein. In diesem Fall können die Führungsschichten 7, 7' gleichzeitig als Mantelschichten für die Lichtführung in der laseraktiven Schicht dienen. Zur lateralen Bündelung des in den Schichten 7 und 7' geführten Empfangslichtes dienen die beiden Streifen 8 und 8', die links und rechts der aktiven Zone im Abstand a und a' angebracht sind. Die Abstände a und a' sind etwa so groß wie die Schichtdicken d und d'. Die Streifen 8 und 8' haben einen kleineren Brechungsindex als die Schichten 7 und 7', so daß das Licht in den Führungsschichten 7 und 7' durch Totalreflexion an den Streifen 8 und 8' lateral geführt wird. Zur vertikalen Führung kann unterhalb der Führungsschicht 7' eine Mantelschicht 9 aufgebracht werden. Nach oben hin besteht Totalreflexion an der Grenzfläche zur Luft, so daß eine spezielle Mantelschicht nicht unbedingt erforderlich ist.

Aus Gründen einer einfacheren Herstellung kann die untere Führungsschicht 7' auch durch den Substratkörper des Halbleiterbauelements selbst gebildet werden. In diesem Fall müßte die Mantelschicht 9 im Substratkörper selbst hergestellt werden. Man könnte aber auch auf die Mantelschicht 9 verzichten, die Führung des Empfangslichtes wäre dann nur durch die lateralen Streifen 8 und 8' und durch die obere Grenzfläche zur Luft gegeben. Auch diese dadurch etwas verschlechterte Führung hätte gegenüber dem Stand der Technik noch einen Vorteil im Koppelwirkungsgrad.

Die obere Führungsschicht 7 kann vorzugsweise aus dem gleichen Material wie das Substrat, also bei InP-Substraten aus InP, durch epitaktisches Aufwachsen hergestellt werden.

Die Mantelstreifen 8 und 8' können entweder aus anderen Materialien oder mit anderen Zusammensetzungen der gleichen Materialien wie in den Schichten 7 und 7' mit niedrigerem Brechungsindex hergestellt werden oder durch eine Dotierung zur Absenkung des Brechungsindexes.

Das Empfangslicht in den Führungsschichten 7 und 7' wird vielmodig geführt, was hier aber nicht von Nachteil ist, da diese Lichtführung unmittelbar vor der Empfangsdiode stattfindet und eine sonst bei vielmodiger Lichtführung störende Modendispersion sich hier nicht mehr negativ auswirken kann. Die Brechzahldifferenz zwischen den Führungs- und Mantelschichten und die Schichtdicken unterliegen daher nicht den strengen Bedingungen, die bei einer einmodigen Lichtführung beachtet werden müssen.

Die minimale Dicke und Breite der Lichtführungsschichten 7 und 7' zwischen den Streifen 8 und 8' wird durch die Güte der Abbildungseigenschaften der Abbildungsoptik 3 vorgegeben und dürfte im Bereich von ca. 5 µm liegen.

Die maximalen Grenzen für die Dicke und Breite der Führungsschichten wird außer von technologischen Randbedingungen von der Größe der verwendeten Photodiode bestimmt, da möglichst alles Licht, daß aus der rückseitigen Stirnfläche der Führungsschichten austritt, in die Photodiode gelangen soll. Da das Empfangslichtbündel etwa mit der gleichen hohen Divergenz aus den Führungsschichten austritt, mit der es eingekoppelt wurde, so sollte die Photodiode möglichst dicht vor dem rückwärtigen Laserfenster angebracht sein. Der Diodenabstand ist entsprechend der Divergenz und der Photodiodengröße zu wählen.

## Patentansprüche

1. Halbleiterlaserstruktur mit einer aktiven Laserschicht (2), die zur Lichterzeugung dient und einen Brechungsindex n₂ aufweist, und mit einem Substrat (1), dadurch gekennzeichnet,
daß oberhalb oder unterhalb der aktiven Laserschicht (2) eine Lichtführungsschicht (7) vorgesehen ist, die den Brechungsindex n₇ aufweist.

2. Halbleiterlaserstruktur nach Anspruch 1, dadurch gekennzeichnet,
daß oberhalb und unterhalb der aktiven Laserschicht (2) eine Lichtführungsschicht (7,7') mit dem Brechungsindex n₇ vorgesehen ist.

3. Halbleiterlaserstruktur nach einem der Ansprüche 1 oder 2, dadurch gekennzeichnet,
daß zur lateralen Bündelung des in den Lichtführungsschichten (7,7') geführten Lichtes Streifen (8,8') vorgesehen sind, die einen Brechungsindex n₈, n₈ < n₇, aufweisen und die sich jeweils zumindest von der oberen Lichtführungsschicht (7) bis zur unteren Lichtführungsschicht (7') erstrecken und diese seitlich begrenzen.

4. Halbleiterlaserstruktur nach einem der Ansprüche 1 bis 3, dadurch gekennzeichnet,
daß zur vertikalen Führung des in den Lichtführungsschichten (7,7') geführten Lichtes oberhalb der oberen Lichtführungsschicht (7) und/oder unterhalb der unteren Lichtführungsschicht, zumindest im Bereich zwischen den Streifen (8,8'). eine Mantelschicht (9) vorgesehen ist, deren Brechungsindex n₉, n₉ < n₇ ist.

5. Halbleiterlaserstruktur nach einem der Ansprüche 1 bis 4, dadurch gekennzeichnet,
daß die Lichtführungsschichten (7,7') aus dem gleichen Material sind wie das Substrat (1).

6. Verwendung einer Halbleiterlaserstruktur nach einem der Ansprüche 1 bis 4 in einer Sende- und Empfangsanordnung für Halbduplexbetrieb, wobei im Empfangsfall das empfangene Licht durch die Lichtführungsschicht der Halbleiterlaserstruktur auf das Empfangselement geführt wird.

7. Anordnung mit einer Halbleiterlaserstruktur nach einem der Ansprüche 1 bis 5, mit einem Lichtwellenleiterende (5) und Halbleiterlaserstruktur und mit einem Empfangselement (6) in Strahlengang hinter der Halbleiterlaserstruktur, wobei im Sendefall Licht von der aktiven Laserschicht (2) der Halbleiterlaserstruktur durch die Optik (3) auf das Lichtwellenleiterende (5) fokussiert wird und im Empfangsfall Licht aus dem Lichtwellenleiterende (5) durch die Optik (3) auf die aktive Laserschicht (2) und die sie umgebenden Lichtführungsschichten (7,7') der Halbleiterlaserstruktur gebündelt wird und durch diese auf das Empfangselement (6) gelangt.

8. Anordnung nach Anspruch 7, dadurch gekennzeichnet,
daß die Halbleiterlaserstruktur und das Empfangselement auf ein Halbleiterbauelement monolithisch integriert sind.
